# EUROPÄISCHE PATENTSCHRIFT

(11) **EP 3 376 668 B1**
(45) Veröffentlichungstag und Bekanntmachung des Hinweises auf die Patenterteilung: **20.01.2021**
(21) Anmeldenummer: 18159875.6
(22) Anmeldetag: 05.03.2018
(51) Int. Cl.: H01H 13/702, H03K 17/97

(54) **TASTSCHALTER**
PUSH-BUTTON SWITCH
INTERRUPTEUR À TOUCHE

(30) Priorität: 17.03.2017 DE 102017105823
(43) Veröffentlichungstag der Anmeldung: 19.09.2018
(73) Patentinhaber: Schaefer GmbH, 72488 Sigmaringen (DE)
(72) Erfinder: Sommer, Lutz, 72458 Albstadt (DE); Parambil Ramachandran, Rinin, 72458 Albstadt (DE)
(74) Vertreter: Rüger Abel Patentanwälte PartGmbB

(56) Entgegenhaltungen:
- EP-A2- 2 267 415
- KR-Y1- 200 202 379

## Beschreibung

Die Erfindung betrifft einen Tastschalter, insbesondere zur manuellen Betätigung und insbesondere mit erhöhter Zuverlässigkeit.

Tastschalter werden einzeln oder in Tastenfeldern zu Bedienzwecken von Maschinen, Einrichtungen, Fahrstühlen der dergleichen genutzt.

Aus der DE 31 45 434 A1 ist eine zu solchen Zwecken geeignete Folientastatur bekannt, die eine Schnappscheibe als elektrisches Kontaktmittel zur wahlweisen Herstellung einer elektrischen Verbindung zwischen Leiterzügen aufweist, die auf einer Basisfolie aufgebracht sind. Die Schnappscheibe wird mittels Tasten manuell betätigt.

Derartige Tastschalter und daraus aufgebaute Tastaturen sind prinzipiell funktionsfähig, jedoch kann durch die Einwirkung der Schnappscheibe auf die Leiterzüge der Basisfolie ein mechanischer und elektrischer Verschleiß auftreten, der die Anzahl der zuverlässig durchführbaren Schaltspiele begrenzt.

Aus der US 4,085,394 ist ein kontaktloser induktiver Schalter bekannt, der solchem Kontaktverschleiß nicht unterliegt. Der Schalter nutzt eine als elektrische Spule dienende Schraubenfeder, deren Induktivität sich abhängig von einer durch ein manuell betätigbares Druckglied herbeigeführte Kompression ändert. Die Induktivitätsveränderung wird zur Erzeugung eines Schaltsignals ausgenutzt. Ein weiterer kontaktloser Schalter mit Sensorspule ist aus der EP 2 267 415 A2 bekannt. Der Sensorspule ist eine manuell deformierbare Schnappfeder zugeordnet, deren zentraler Teil sich bei Betätigung an die Sensorspule annähert. Die dadurch eintretende Induktivitätsveränderung wird von einer Detektorschaltung erfasst und in ein Schaltsignal umgesetzt.

Es ergibt sich ein Aufbau beträchtlicher Höhe, der nicht zur Gestaltung flacher Tastaturen geeignet ist.

Aus der DE 10 2014 212 627 A1 ist dagegen eine Tastatur bekannt, die auf einer mehrlagigen Leiterplatte aufbaut. Diese enthält eine Induktionsspule, die durch einen mit einer Taste verbundenen Magneten beeinflusst wird, um ein Schaltsignal zu erzeugen. Außerdem ist der Taste ein mechanischer Schaltkontakt zugeordnet, mit dem sich ebenfalls ein Schaltsignal erzeugen lässt.

Diese Tastatur eignet sich insbesondere als Computertastatur. Sie weist jedoch einen aufwendigen Aufbau und eine erhebliche Bauhöhe auf.

Es ist Aufgabe der Erfindung, einen flach bauenden Tastschalter anzugeben, der auch in widriger Umgebung zuverlässig und langzeitstabil arbeitet.

Diese Aufgabe wird mit dem Tastschalter nach Anspruch 1 gelöst:

Der erfindungsgemäße Tastschalter weist zumindest eine aus einer gedruckten Leitung bestehende Spule auf, der ein elektrisch leitfähiges zwischen einer Nahposition und Fernposition verstellbares leitfähiges Steuerelement zugeordnet ist, wobei das Steuerelement mittels eines Betätigungselements bewegbar ist und wobei zwischen dem Leitungsträger und dem Betätigungselement eine Schnappscheibenfeder wirksam ist.

Damit wird insgesamt ein sehr flacher und robuster Aufbau erreicht. Die Erzeugung des Schaltsignals erfolgt kontaktlos durch Beeinflussung der Induktivität der Spule. Diese ist vorzugsweise als Flachspule ausgebildet. Zur Herstellung können verschiedene Technologien genutzt werden, beispielsweise Leiterplattentechnologien, Aufdrucken leitfähiger Tinte auf folienartige oder auch plattenartige steife Träger, usw. Die Spule ist dabei vorzugsweise eine Flachspule. Sie kann im Körper eines flächigen Trägers, zwischen Folien oder anderweitig geschützt untergebracht sein.

Das Steuerelement besteht aus einem Metall oder einem Kunststoff. Das Metall kann ein diamagnetisches Metall, ein magnetisierbares Metall mit geringer oder großer Koerzivität sein. Der Kunststoff kann ein elektrisch leitfähiger Kunststoff, ein mit elektrisch leitfähigen und/oder weich- oder hartmagnetischen Partikeln oder Elementen versehener Kunststoff sein. Die Partikel können gleichmäßig oder ungleichmäßig im Kunststoff verteilt sein. Ein oder mehrere elektrisch leitfähige, weich- oder hartmagnetische Elemente können in den Kunststoff eingebettet oder an diesem angebracht sein. Insbesondere kann das Metallelement bei einer Ausführungsform der Erfindung auch von der Schnappscheibenfeder selbst und dabei insbesondere von deren äußeren Rand gebildet sein, der sich bei Bewegung des Betätigungselements an die Spule annähert oder bei Loslassen von dieser entfernt. Die mittlere, vorzugsweise domartig gewölbte, Zone der Schnappscheibenfeder bewegt sich hingegen bei Betätigung des Tastschalters wenig oder nicht. Unabhängig davon, ob die Schnappscheibe als Steuerelement dient oder dieses von der Schnappscheibe gesondert ausgebildet ist, stützt sich dieser gewölbte Teil der Schnappscheibenfeder mittelbar oder unmittelbar an dem Leitungsträger, vorzugsweise in einem Bereich ab, der von der Flachspule konzentrisch umgeben ist, selbst aber von Leiterzügen frei ist.

Bei Druckausübung auf das Betätigungselement spürt die betätigende Person zunächst einen gewissen Widerstand mit einem überwindbaren Druckpunkt. Die Spule und das Steuerelement (das durch das Betätigungselement oder die Schnappscheibe bzw. deren äußere Zone gebildet sein können) bilden einen Näherungsschalter, der das Schaltsignal erzeugt, indem die Spule bei unbetätigtem und betätigtem Zustand des Betätigungselements unterschiedliche elektrische Eigenschaften aufweist. Eine an die Spule angeschlossene Auswerteschaltung erzeugt anhand der wechselnden elektrischen Eigenschaften der Spule ein Schaltsignal, so dass die Spule und das Steuerelement gegebenenfalls im Zusammenspiel mit der Auswerteschaltung einen kontaktlosen elektrischen Schalter bilden. Dieser unterliegt keinem Kontaktverschleiß, baut äußerst flach und kann aufgrund seines robusten Aufbaus, insbesondere der Unterbringung der Spule nebst Zuleitungen hinter einer Schutzfolie, auch in widriger Umgebung eingesetzt werden. Damit können derartige Tastschalter an Maschinen, im öffentlichen Bereich oder auch in einem Verschmutzungen ausgesetzten Bereich eingesetzt und bedarfsweise auch auf einfache Weise vandalensicher ausgebildet werden. Die Vandalismussicherheit resultiert aus einem optinal vorsehbaren zusätzlichen Ring, der an der dem Nutzer abgewandten Seite des Schaltknopfs angebracht ist und eine Bewegungsbegrenzung des Schaltkopfes darstellt.

Die Auswerteschaltung ist vorzugsweise derart ausgebildet, dass sie dauernd oder periodisch ein Wechselspannungssignal an die Spule leitet, um deren elektrische Eigenschaft zu prüfen. Die zu überprüfende elektrische Eigenschaft kann die Induktivität der Spule, ihr wirksamer ohmscher Widerstand, ihre Güte, ihr Verlustfaktor, ihr Verlustwinkel, ihre Zeitkonstante oder eine mit einem gegebenen Kondensator festgelegte Resonanzfrequenz oder ähnliches sein. Der wirksame ohmsche Widerstand setzt sich dabei aus ihrem eigenen Widerstand sowie den durch transformatorische Kopplung zur Schnappscheibe und/oder zum Steuerelement herrührenden Verlustwiderstand zusammen. Die Zeitkonstante der Spule ist der Quotient aus der Spuleninduktivität L und dem ohmschen Widerstand R der Spule. Vorzugsweise ist die Zeitkonstante geringer als 1 µs, weiter vorzugsweise geringer als 0,5 µs und im am meisten bevorzugten Fall geringer als 0,1 µs. Eine derart geringe Zeitkonstante der Spule führt zu einer weitgehenden Störungsunempfindlichkeit des induktiven Tastschalters, der somit keinen unbeabsichtigten Betätigungen durch metallische Gegenstände unterliegt, die zum Beispiel ohne das Betätigungselement zu bewegen, außen an dieses angelegt werden. Die geringe Zeitkonstante führt zu einer geringen Güte der Spule sowie auch eines unter Einschluss der Spule aufgebauten Schwingkreises. Damit wird die Empfindlichkeit gegen äußere Störungen reduziert und das Annähern des Steuerelements an die Spule sicher erfasst, während andere in der Nähe stattfindende Bewegungen metallischer Objekte in der Regel kein Schaltsignal auslösen. Im Fall von äußeren Störungen kann eine zusätzliche elektromagnetische Abschirmung verwendet werden und bzw. oder spezifische obere und untere Grenzwerte für Schaltvorgänge definiert werden.

Die gewünschte niedrige Zeitkonstante der Spule wird vorzugsweise erhalten, indem die Spule aus einem auf den Leitungsträger aufgebrachten Aufdruck aus leitfähiger Tinte, einer Leitpaste, eine Leitlacks oder dergleichen erzeugt wird. Damit hat die Spule einen entlang ihrer Windungen verteilten ohmschen Widerstand vorzugsweise zwischen 0,2 Ohm und 20 Ohm, vorzugsweise 2 bis 12 Ohm, wobei sie vorzugsweise eine Induktivität zwischen 0,1 µH und 20 µH, vorzugsweise zwischen 0,5 µH und 5 µH aufweist. Die Spule weist typischerweise eine geringe Windungszahl mit weniger als 10 Windungen auf. Die äußeren Abmessungen der Spule sind vorzugsweise höchstens so groß wie die äußeren Abmessungen des Betätigungselements oder des Steuerelements. Der innere, von den Windungen der Spule umgebene und von Leiterzügen freie Teil der Spule ist vorzugsweise wenigstens so groß, wie der an dem Spulenträger anliegende Teil der Schnappscheibenfeder. Vorzugsweise sind die Abmessungen des von Leiterzügen freien Teils so groß wie die Abmessungen der Schnappscheibenfeder.

Das Steuerelement kann, wie ausgeführt, durch die Schnappfeder selbst gebildet sein, wobei diese aus einem Metall oder einem elektrischen leitfähigen Kunststoffmaterial bestehen kann. Alternativ kann, wie oben erläutert, ein gesondertes Steuerelement, beispielsweise in Gestalt eines leitfähigen Rings, vorgesehen sein, der die Schnappfeder umgibt. Der leitfähige Ring kann das Betätigungselement selbst oder ein gesondertes Element sein. Es kann aus leitfähigem Kunststoff oder Metall gebildet sein. Bei Verwendung eines elektrischen leitfähigen Betätigungselements oder eines die Schnappfeder umgebenden elektrisch leitfähigen Elements kann die Veränderung der Induktivität oder einer sonstigen elektrischen Eigenschaft der Spule auch durch das Zusammenspiel der Bewegung aller leitfähigen Elemente bei Betätigung des Tastschalters hervorgerufen werden.

Zusätzlich zu dem von der Spule und dem Steuerelement gebildeten kontaktlosen Schalter ist ein Kontaktschalter vorgesehen, der vorzugsweise als Folienschalter ausgebildet ist. Zu dem Kontaktschalter gehört ein Kontaktsatz, der durch eine Folienanordnung gebildet ist. Diese umfasst vorzugsweise wenigstens eine Leitungsträgerfolie, eine Distanzfolie und eine Schaltkontaktträgerfolie. Die Schnappscheibenfeder stützt sich direkt oder durch ein Druckübertragungselement mittelbar auf der Folienanordnung ab, so dass der betreffende Kontakt der Schaltkontaktträgerfolie die Kontakte der Leitungsträgerfolie berührt, wenn eine ausreichende Kraft auf das Betätigungselement ausgeübt wird. Die Kontaktgabe des Kontaktschalters kann dabei bereits vor Überwindung des Druckpunkts der Schnappfeder erfolgen. Die Kontaktgabe kann dann nach Überwindung des Druckpunts aufhören oder je nach Federcharakteristik der Schnappscheibenfeder weiter fortbestehen.

Bei korrekter Arbeitsweise des intakten Tastschalters ergibt sich eine charakteristische Koinzidenz von Kontaktgabe des Kontaktschalters und (z.B. nachfolgendem) Ansprechen des Sensorschalters. Die Auswerteschaltung kann das Vorliegen dieser Koinzidenz prüfen und anhand von Abweichungen Verschleißzustände erkennen, bevor diese zum Ausfall des Tastschalters führen.

Weitere Einzelheiten vorteilhafter Ausführungsformen von erfindungsgemäßen Tastschaltern sind Gegenstand der Zeichnung und der zugehörigen Beschreibung. Es zeigen:
Figur 1 Eine Tastatur mit beispielhaften Tastschaltern, in schematisierter längsgeschnittener Darstellung,
Figur 2 eine sehr schematische Explosionsdarstellung eines Tastschalters nach Figur 1,
Figur 3 ein weiteres Beispiel eines Tastschalters,
Figur 4 und 5 Tastschalter mit zusätzlichem Kontaktschalter, in schematisierter Explosionsdarstellung,
Figur 6 Leitungsträger mit Spulen für den Tastschalter nach einem der vorstehenden Figuren,
Figur 7 eine Leitungsträgerfolie für den Kontaktsatz eines Tastschalters nach Figur 4 oder 5 und
Figur 8 eine Schaltkontaktträgerfolie für den Kontaktsatz eines Tastschalters nach Figur 4 oder 5.

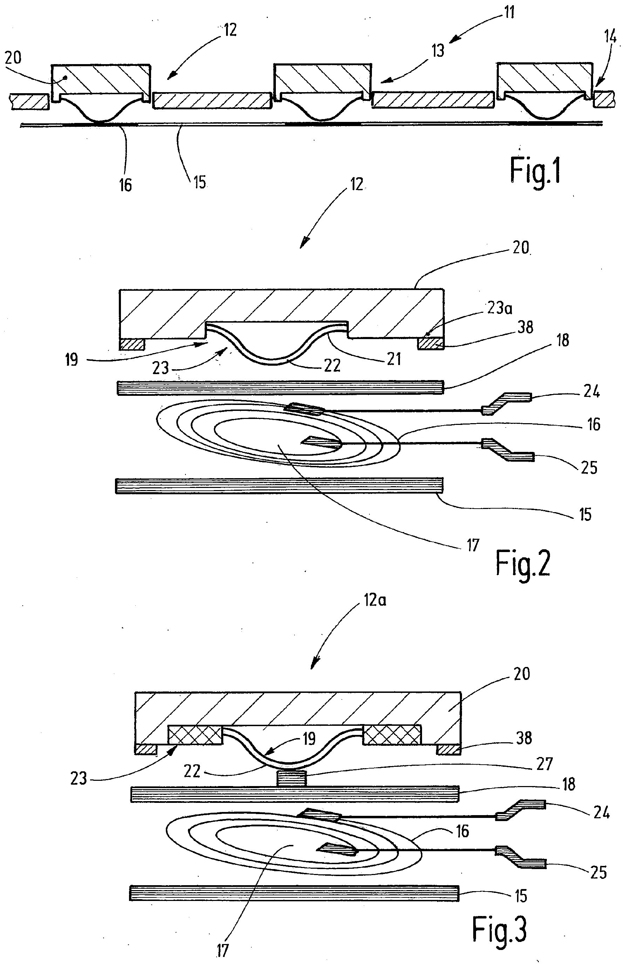

In Figur 1 ist ein Tastenfeld 11 im Längsschnitt schematisiert und vereinfacht veranschaulicht, wobei das Tastenfeld 11 mehrere prinzipiell ähnlich oder gleich aufgebaute Tastschalter 12, 13, 14 aufweist, die unabhängig voneinander betätigbar sind. Die nachfolgende Beschreibung des Tastschalters 12 gilt entsprechend für alle anderen Tastschalter des Tastenfelds 11.

Der Tastschalter 12 ist in seine wesentlichen Komponenten schematisiert in Figur 2 in expandierter Darstellung veranschaulicht. Zu dem Tastschalter 12 gehört ein Leitungsträger 15, der flexibel zum Beispiel als Folie ausgebildet und zur Unterstützung auf einem nicht weiter veranschaulichten starren Träger angeordnet sein kann oder der selbst als starre Platte ausgebildet ist. Er kann dazu in nicht weiter veranschaulichten Versteifungseinrichtungen versehen sein.

Der Leitungsträger 15 besteht vorzugsweise aus einem elektrisch nicht leitenden, vorzugsweise dielektrisch verlustarmen Kunststoff. Zu dem Tastschalter 12 gehört weiter eine auf dem Leitungsträger 15 aufgebrachte Spule 16, die als Flachspule ausgebildet ist. Sie weist wenigstens eine, vorzugsweise aber mehrere Windungen auf, die um einen zentralen von Windungen und vorzugsweise auch sonstigen Leitern frei gelassenen Bereich 17 herumführen. Die Windungen können rund sein, d.h. einer Spirale folgen, oder alternativ anderweitig ausgebildet sein, zum Beispiel einer Polygonalform folgen. Beispielsweise kann die Spule 16 als Rechteckspule ausgebildet sein.

Die Spule 16 wird durch einen Leiterzug gebildet, der vorzugsweise aus einem Material mit einem Leitwert geringer als Kupfer ausgebildet ist, so dass die Spule insgesamt einen ohmschen Widerstand von einigen Ohm, insbesondere im Bereich zwischen 0,2 Ohm und 20 Ohm aufweist. Bei der bevorzugten Ausführungsform sind Leitungsmaterial sowie Leiterzugdicke und Leiterzugbreite so aufeinander abgestimmt, dass sich ein Spulenwiderstand von etwa 2 Ohm bis 12 Ohm ergibt. Die Induktivität der Spule liegt typischerweise zwischen 0,1µH und 20µH. Die von der Spule festgelegte Zeitkonstante L/R (Induktivität geteilt durch Widerstand) liegt vorzugsweise bei 10⁻⁷ s oder etwas darunter.

Vorzugsweise, jedoch optional, ist der mit der Spule 16 versehene Leitungsträger 15 mit einer Abdeckschicht 18, zum Beispiel in Gestalt einer Schutzfolie aus elektrisch nicht leitendem vorzugsweise dielektrisch verlustarmen Kunststoff versehen. Die Abdeckschicht 18 kann zum Schutz der Spule 16 gegen mechanische Beschädigung gegen Umwelteinflüsse und dergleichen dienen. Die Abdeckschicht 18 kann dabei flexibel oder auch selbst steif ausgebildet sein. Vorzugsweise ist sie flächenhaft mit dem Leitungsträger 15 verbunden. Alternativ kann sie auch lediglich stellenweise mit diesem verbunden sein und ansonsten lose aufliegen. Außerdem ist es möglich, die Abdeckschicht 18 durch einen Lack auszubilden, der die Spule 16 überdeckend vollflächig oder lediglich die Leiterzüge und Spulen bedeckend auf dem Leitungsträger 15 aufgebracht ist.

Der Spule 16 ist eine Schnappscheibenfeder 19 zugeordnet, die in eine entsprechende Aufnahme eines Betätigungselements 20 eingesetzt ist oder auf andere Weise mit dieser verbunden ist. Vorzugsweise steht der äußere Rand 21 mit dem Betätigungselement 20 in Verbindung, während der mittlere, vorzugsweise gewölbte Teil 22 der Schnappscheibenfeder 19 an der Abdeckschicht 18 anliegt. Der gewölbte Teil 22 ist zu der Spule 16 hin konvex gewölbt und liegt vorzugsweise in dem windungsfreien Zentralbereich der Spule 16 an der Abdeckschicht 18 an.

Die Schnappscheibenfeder 19 ändert beim Niederdrücken des Betätigungselements 20 ihre Form, wobei sich insbesondere der Randbereich 21 der Schnappscheibe näher an die Spule 16 annähert. Damit kann die Schnappscheibenfeder 19 zugleich ein Steuerelement 23 zur gezielten Beeinflussung wenigstens eines elektrischen Parameters der Spule 16 bilden. Insbesondere beeinflusst das Steuerelement 23 die Induktivität der Spule 16 und/oder die Wirbelstromverluste derselben. Dies gilt insbesondere, wenn der Außendurchmesser der Schnappscheibenfeder 19 größer ist, als der Innendurchmesser der Spule 16.

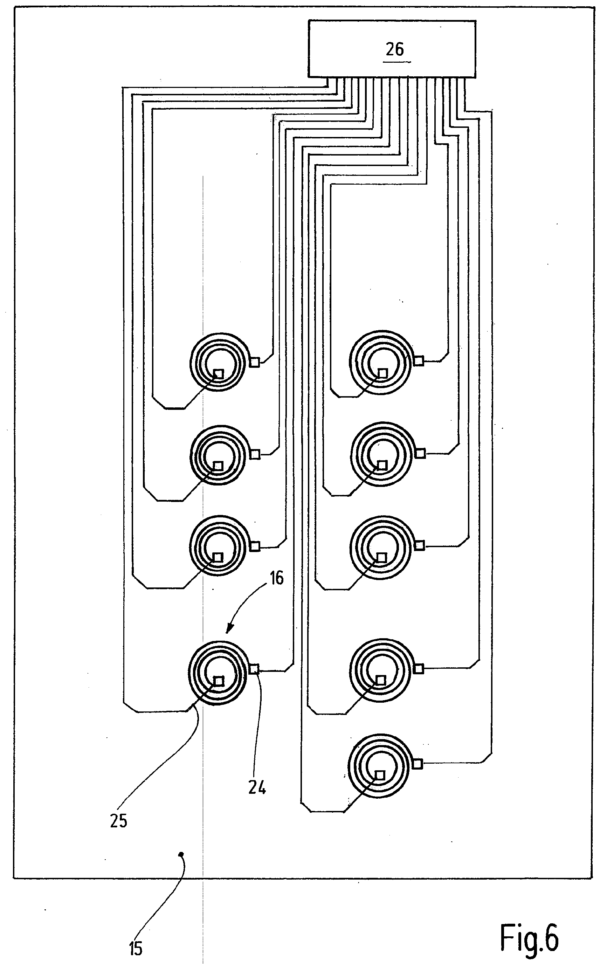

An die Enden 24, 25 der Spule 16 sind, wie sich aus dem Leitungsführungslayout gemäß Figur 6 ergibt, Leiterzüge angeschlossen, die die Spule 16 mit einer Auswerteschaltung 26 zum Beispiel in Gestalt eines Mikrocontrollers verbinden. Auch alle anderen Spulen des Leitungsträgers 15 sind mit der gleichen oder weiteren Auswerteschaltungen verbunden.

Der insoweit beschriebene Tastschalter 12 arbeitet wie folgt:
Der Tastschalter 12 ist in seiner unbetätigten Stellung in Figur 1 veranschaulicht. Das Betätigungselement 20 befindet sich on einer von der Spule 16 fernen Position. Durch die Nachbarschaft der Schnappscheibenfeder 21 zu der Spule 16 weist die Spule 16 eine bestimmte vorgegebene Induktivität und bestimmte Wirbelstromverluste auf. Die Auswerteschaltung 26 testet dies fortwährend oder periodisch durch Beaufschlagung der Spule 16 mit Strom- oder Spannungsimpulsen und durch Beobachtung der daraus resultierenden Spannung bzw. des daraus resultierenden Stroms. Die Eigenschaften der Spule 16 ändern sich jedoch, wenn das Bedienelement 20 niedergedrückt wird. Dabei muss zunächst der von der Schnappscheibenfeder 19 festgelegte Druckpunkt überwunden werden, wonach das Betätigungselement 20 als Taste spürbar nachgibt. Der Randbereich 21 der Schnappscheibenfeder 19 nähert sich nun der Spule 16, wodurch sich deren elektrische Eigenschaften, insbesondere ihre Induktivität und die Wirbelstromverlusten ändern. Die Auswerteschaltung 26 erfasst dies und leitet daraus das Schaltsignal "Ein" ab. Wird das Betätigungselement 20 wieder losgelassen, kehren die elektrischen Eigenschaften der Spule 16 auf ihre Ursprungswerte zurück und es wird von der Auswerteschaltung 26 das Signal "Aus" generiert.

Durch den statisch vorhandenen ohmschen Widerstand R der Spule 16 ergibt sich eine sehr niedrige Ansprechempfindlichkeit der Spule 16 auf metallische Gegenstände, die sich in etwas größerer Entfernung von der Spule 16 befinden als die Schnappscheibenfeder 19. Deswegen ist die Störempfindlichkeit des Tastschalters 12 gering.

Bei einer weiteren wichtigen Ausführungsform der Erfindung wird das Steuerelement 23 nicht durch die Schnappscheibenfeder 19, sondern durch das Betätigungselement 20 gebildet. Dies bedeutet bezogen auf die Darstellung in Figur 2, dass das Betätigungselement 20 aus einem elektrisch leitfähigen Material gebildet oder alternativ mit einem Element aus solchem Material verbunden ist. Das Material kann beispielsweise Metall, ein elektrisch extrinsisch oder intrinsisch leitender Kunststoff oder auch ein mit magnetischen Partikeln, wie zum Beispiel Ferritpulver oder dergleichen, gefüllter Kunststoff sein. Bei dieser Ausführungsform ist der windungsfreie Zentralbereich 17 der Spule 16 vorzugsweise wenigstens annähernd so groß wie die Schnappscheibenfeder 19, wohingegen die der Abdeckschicht 18 zugewandten Teile des Betätigungselements 20 das Steuerelement 23a bilden (Figur 1). Wiederum dient die Spule 16 als Sensor für das Annähern oder Entfernen des Betätigungselements 20 von diesem Punkt. Der Außendurchmesser der Spule 16 ist vorzugsweise höchstens so groß wie der Außendurchmesser des Betätigungselements 20 oder des Steuerelements 23. Bei runden wie bei unrunden Betätigungselementen oder Steuerelementen ist die Form und Größe der Spule jeweils wenigstens näherungsweise an Form und Größe des Betätigungselements und/oder des Steuerelements angepasst. Vorzugsweise stimmen die Spule und das Steuerelement oder das Betätigungselement in Form und Größe miteinander überein.

Wie ersichtlich, können sowohl das Betätigungselement 20 als auch die Schnappscheibenfedern 19 gemeinsam oder alternativ, je nach Ausführungsform, als Steuerelement zur Beeinflussung der Spule 16 dienen.

Figur 3 veranschaulicht weitere Optionen, die an einem erfindungsgemäßen Tastschalter verwirklicht werden können. Für den in Figur 3 veranschaulichten Tastschalter 12a gilt die vorstehende Beschreibung unter Zugrundelegung der eingeführten Bezugszeichen entsprechend. Abweichend von der obigen Beschreibung und ergänzend gilt, dass der mittlere, vorzugsweise gewölbte Teil 22 der Schnappscheibenfeder 19 nicht unmittelbar, sondern mittelbar an der Abdeckschicht 18 anliegt, indem zwischen dem gewölbten Teil 22 und der Abdeckschicht 18 ein Pufferelement 27 angeordnet ist. Dieses besteht vorzugsweise aus einem reibungsarmen Kunststoff, wie zum Beispiel PTFE oder dergleichen. Es kann mit der Abdeckschicht 18 oder alternativ mit der Schnappscheibenfeder 19 verbunden sein. Der von dem Pufferelement geschaffene Abstand der Abdeckschicht 18 und der Schnappscheibenfeder 22 kann genutzt werden, um deren Federkennlinie zu beeinflussen und Verschleiß und Reibung zu mindern.

Bei dem erfindungsgemäßen Tastschalter 12, 12a ist es außerdem möglich, weder die Schnappscheibenfeder 19 noch das Betätigungselement 20 als Steuerelement zu nutzen, sondern vielmehr an dem Betätigungselement, an der der Spule 16 zugewandten Seite ein solches gesondertes Steuerelement 23 anzubringen. Dieses kann beispielsweise als ein die Peripherie der Schnappscheibenfeder 19 umgebender Ring ausgebildet sein, der die Schnappscheibenfeder 19 umgibt oder durch einzelne Elemente, die zum Beispiel einander berührend oder mit zwischen einander vorhandenen Lücken die Schnappscheibenfeder 19 im Viereck umgeben und an dem Betätigungselement 20 befestigt sind. Das Steuerelement 23 besteht wiederum aus einem stromleitenden Material, zum Beispiel Metall oder elektrisch leitendem Kunststoff. Bei der bevorzugten Ausführungsform als geschlossener Ring können sich in diesem Steuerelement durch transformatorische Kopplung mit der Spule 16 Wirbelströme ausbilden, deren Größen davon abhängt, ob das Betätigungselement 20 betätigt ist oder nicht. Daraus leitet die Auswerteschaltung 27 wiederum die Schaltsignale "Ein" und "Aus" ab.

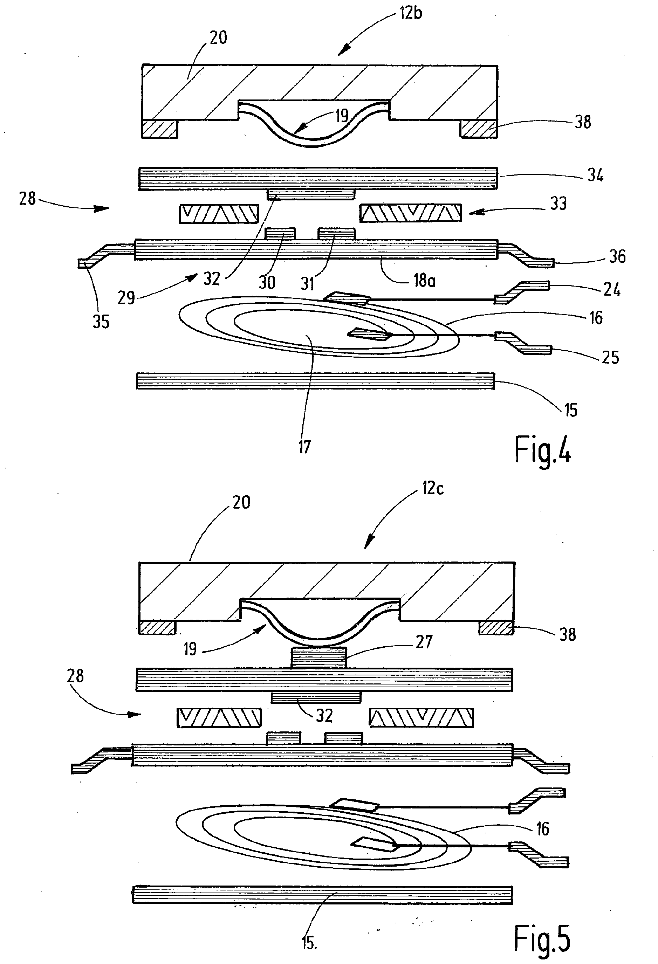

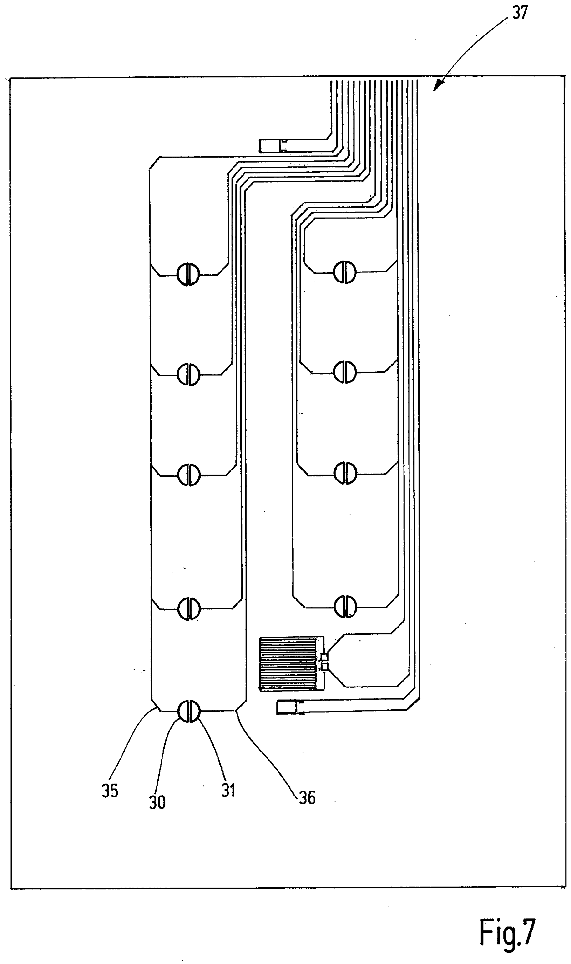

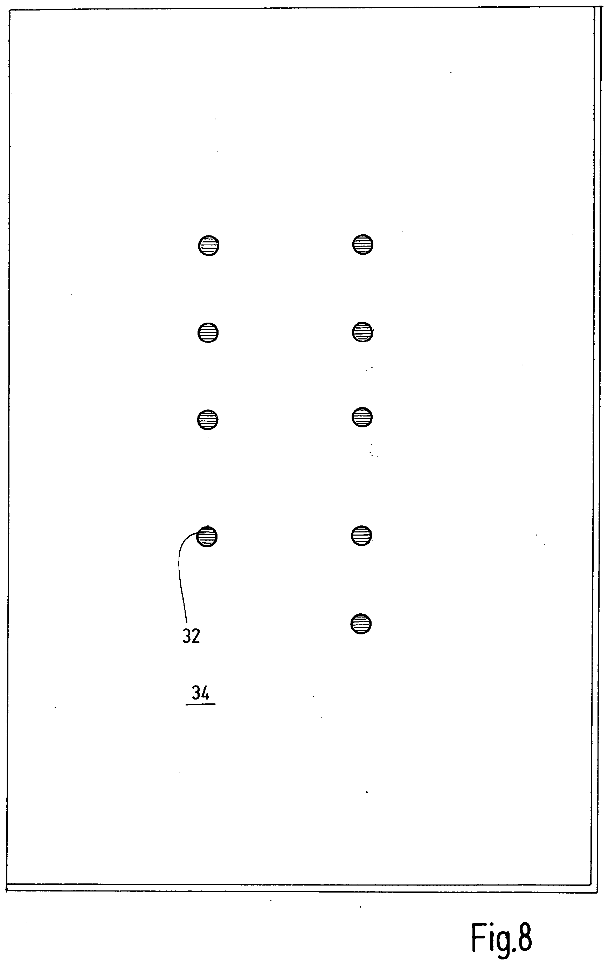

Figur 4 veranschaulicht eine andere abgewandelte Ausführungsform des erfindungsgemäßen Tastschalters 12b, wobei diese zwischen der Spule 16 und der Schnappfeder 19 einen Kontaktsatz 28 aufweist. Dieser beinhaltet einen Kontaktschalter 29, der aus wenigstens zwei stationären Kontakten 30, 31 und einem beweglichen Schaltkontakt 32 besteht. Die stationären Kontakte 30, 31 können auf der Abdeckschicht 18a angeordnet sein, wie sie in Figur 7 in Draufsicht dargestellt ist und die somit eine Kontaktträgerfolie bildet. Auf dieser ist eine Distanzschicht 33 angeordnet (Figur 5), die Ausschnitte für die Kontakte 30, 31 aufweist. Die Distanzschicht 33 kann aus Kunststoff, Papier oder dergleichen bestehen. Auf der Distanzschicht liegt wiederum eine Schaltkontaktträgerfolie 34, die den beweglichen Kontakt 32 trägt und in Figur 8 dargestellt ist. Entgegen der Darstellung der Einzelelemente in Figur 4 liegen der Leitungsträger 15, die Abdeckschicht 18a, die Distanzschicht 33 und die Schaltkontaktträgerfolie 34 aneinander an, wobei sie stellenweise oder ganzflächig miteinander verbunden sind oder sein können.

Von den Kontakten 30, 31 ausgehende Leitungen 35, 36 führen, wie aus Figur 7 hervorgeht, zu einem äußeren Anschluss 37 und können dort durch einen entsprechenden Stecker kontaktiert werden. Damit kann der Kontaktsatz 29 der Folienanordnung 28 als normaler elektrischer Taster genutzt werden. Der Kontakt schließt, d.h. der bewegliche Kontakt 32 berührt die Kontakte 30, 31, wenn durch Druckausübung auf das Betätigungselement 20 der Druck der Schnappscheibenfeder 19 auf die Schaltkontaktträgerfolie 34 und somit den direkt darunter liegenden beweglichen Kontakt 32 so groß wird, dass sich die Schaltkontaktträgerfolie 34 in die Öffnung der Distanzschicht 33 hinein wölbt und der bewegliche Kontakt 32 die Kontakte 30, 31 überbrückt. Die Konfiguration kann dabei so getroffen sein, dass der Kontakt aufrechterhalten wird, wenn die Schnappscheibenfeder 19 über ihren Druckpunkt gelangt. Alternativ kann die Konfiguration so getroffen sein, dass die Kontaktgabe nach Passieren des Druckpunkts aufhört. In beiden Fällen kann der Tastschalter 12b als Kontaktschalter direkt Schaltaufgaben übernehmen.

Es ist auch möglich, den Kontaktschalter mit der Auswerteschaltung 27 zu verbinden, so dass diese die Koinzidenz der Kontaktgabe des Kontaktschalters mit dem Ansprechen der Spule 16 überprüft. Spricht bei Betätigung nur einer der beiden Schalter an oder verschiebt sich das typische Muster der zeitlichen Folge der Schaltereignisse der beiden Schalter relativ zueinander, ist die ein Kennzeichen für eine möglicherweise schädliche Veränderung des Tastschalters 12. Die Auswerteschaltung 26 kann so ausgebildet sein, dass sie dies überprüft, erkennt und signalisiert.

Eine weitere Abwandlung des Tastschalters 12 oder 12a, nach Figur 2 oder 3 veranschaulicht die Figur 5 in Gestalt des Tastschalters 12c. Das Betätigungselement 20 sowie die Folienanordnung 28, die Schnappscheibenfeder 19 und die Spule 16 sowie der Spulenträger 15 können jede der vorbeschriebenen Konfigurationen haben. Ergänzend gilt, dass zwischen der Schnappscheibenfeder 19 ein Puffer 27 vorgesehen sein kann, der zur Beeinflussung der Federkennlinie, zur Verschleißminderung sowie zur Konzentration der von der Schnappscheibenfeder 19 ausgehenden Betätigungskräfte auf den beweglichen Kontakt 32 dienen kann.

Wie in den Figuren 2 - 5 dargestellt, ist es optional möglich, ein Hubbegrenzungsmittel für das Betätigungselement 20 vorzusehen. Dazu kann an der Rückseite des Betätigungselements 20 ein Abstandshalter 38, z.B. in Gestalt eines zu der Schnappfeder 19 konzentrischen Ringes oder in Form anderer Vorsprünge vorgesehen sein. Alternativ kann der Abstandshalter 38 mit der Folienanordnung verbunden sein, z.B. indem er auf die Schutzfolie 18 aufgebracht ist.

Der erfindungsgemäße Tastschalter weist eine hermetisch versiegelte, als Näherungssensor dienende Spule 16 auf, der ein beweglich gelagertes Steuerelement 21 zugeordnet ist. Dieses lässt sich durch ein Betätigungselement an die Spule 16 annähern oder von dieser entfernen, wobei die Bewegung parallel zur Axialrichtung der Spule 16 stattfindet. Die Spule 16 ist vorzugsweise eine Flachspule und das Steuerelement ist ein elektrisch leitfähiges und/oder magnetisch leitfähiges weich- oder hartmagnetisches Material, das Teil des Betätigungselements 20 und/oder Teil der Schnappfeder 19 sein kann. Eine Auswerteschaltung 26 erfasst Änderung der elektrischen Eigenschaften der Spule 16 bei Bewegung des Betätigungselements 20 und generiert daraus ein Schaltsignal.

### Bezugszeichen

| | |
|---|---|
| 11 | Tastenfeld |
| 12, 12a-c, 13, 14 | Tastschalter |
| 15 | Leitungsträger |
| 16 | Spule |
| 17 | windungsfreier Zentralbereich der Spule 16 |
| 18, 18a | Abdeckschicht |
| 19 | Schnappscheibenfeder |
| 20 | Betätigungselement |
| 21 | Randbereich der Schnappscheibenfeder |
| 22 | gewölbter Teil der Schnappscheibenfeder |
| 23, 23a | Steuerelement |
| 24, 25 | Anschlüsse der Spule 16 |
| 26 | Auswerteschaltung |
| 27 | Pufferelement |
| 28 | Folienanordnung |
| 29 | Kontaktsatz |
| 30, 31 | stationäre Kontakte |
| 32 | beweglicher Kontakt |
| 33 | Distanzschicht |
| 34 | Schaltkontaktträgerfolie |
| 35, 36 | Leitungen |
| 37 | Anschluss |
| 38 | Abstandsring |
| | |
| | |
| | |
| | |

## Patentansprüche

1. Tastschalter, insbesondere zur manuellen Betätigung, mit einem Leitungsträger (15), der mindestens eine aus einer gedruckten Leitung bestehende Spule (16) aufweist,
mit einem elektrisch leitfähigen Steuerelement (23), das der Spule (16) zugeordnet ist und dessen Nähe zu der Spule (16) zwischen einer Fernposition und einer Nahposition veränderbar ist,
mit einem Betätigungselement (20) das mit dem Steuerelement (23) mechanisch verbunden ist,
mit einer Schnappscheibenfeder (19), die zwischen dem Leitungsträger (15) und dem Betätigungselement (20) wirksam ist,
**dadurch gekennzeichnet,**
**dass** zwischen der Srhnappscheibenfeder (19) und der Spule (16) ein Kontaktsatz (29) angeordnet, ist, der einen Kontaktschalter bildet.

2. Tastschalter nach Anspruch 1, **dadurch gekennzeichnet, dass** die Spule (16) elektrisch mit einer Auswerteschaltung (27) verbunden ist, die wenigstens eine elektrische Eigenschaft der Spule (16) erfasst, um anhand dessen Veränderung ein Schaltsignal zu erzeugen und so einen kontaktlosen Schalter zu bilden.

3. Tastschalter nach Anspruch 2, **dadurch gekennzeichnet, dass** die Auswerteschaltung (27) derart ausgebildet ist, dass sie dauernd oder periodisch ein Wechselspannungssignal an die Spule (16) leitet.

4. Tastschalter nach Anspruch 2, **dadurch gekennzeichnet, dass** die elektrische Eigenschaft der Spule (16) deren Induktivität, ihr wirksamer ohmscher Widerstand, ihre Güte, ihr Verlustfaktor, ihr Verlustwinkel, ihre Zeitkonstante oder eine mit einem gegebenen Kondensator festgelegt Resonanzfrequenz ist.

5. Tastschalter nach einem der vorstehenden Ansprüche, **dadurch gekennzeichnet, dass** die Spule (16) bei Abwesenheit des Steuerelements (23) eine Zeitkonstante (L/R) aufweist, die geringer als 1 µs, vorzugsweise geringer als 0,5 µs und bevorzugterweise geringer ist als 0,1 µs ist.

6. Tastschalter nach einem der vorstehenden Ansprüche, **dadurch gekennzeichnet, dass** die Spule (16) aus einem auf den Leitungsträger (15) aufgebrachten Aufdruck aus leitfähiger Tinte besteht.

7. Tastschalter nach einem der vorstehenden Ansprüche, **dadurch gekennzeichnet, dass** die Spule einen ohmschen Widerstand zwischen 0,2 Ohm und 20 Ohm, vorzugsweise zwischen 2 Ohm und 12 Ohm sowie vorzugsweise eine Induktivität zwischen 0,1 µH und 20 µH, weiter vorzugsweise zwischen 0,5 µH und 2 µH aufweist.

8. Tastschalter nach einem der vorstehenden Ansprüche, **dadurch gekennzeichnet, dass** die Spule (16) zwischen dem Leitungsträger (15) und einer Schutzschicht (18) angeordnet ist.

9. Tastschalter nach einem der vorstehenden Ansprüche, **dadurch gekennzeichnet, dass** das Steuerelement (23) aus einem Metall oder einem elektrisch leitfähigen Kunststoffmaterial besteht.

10. Tastschalter nach einem der vorstehenden Ansprüche, **dadurch gekennzeichnet, dass** das Steuerelement (23) von der Schnappscheibenfeder (19) selbst gebildet ist.

11. Tastschalter nach einem der vorstehenden Ansprüche, **dadurch gekennzeichnet, dass** die Schnappscheibenfeder (19) eine Wölbung aufweist, deren konvexe Seite der Spule (16) zugewandt ist.

12. Tastschalter nach Anspruch 1, **dadurch gekennzeichnet, dass** der Kontaktsatz (29) durch eine Folienanordnung (28) gebildet ist.

13. Tastschalter nach Anspruch 8, **dadurch gekennzeichnet, dass** die Schutzschicht (18) durch eine Leitungsträgerfolie der Folienanordnung (28) gebildet ist, auf der eine Distanzfolie (33) angeordnet ist, die mit einer Schaltkontaktträgerfolie (34) versehen ist.

14. Tastschalter nach einem der Ansprüche 2-13 wobei die Auswerteschaltung teschaltung (27) darauf eingerichtet ist, die Koinzidenz der Betätigung des kontaktlosen Schalters und des Kontaktschalters zu prüfen.

## Claims

1. Pushbutton switch, in particular for manual actuation, with a line carrier (15) which has at least one coil (16) consisting of a printed line,
with an electrically conductive control element (23) which is assigned to the coil (16) and whose proximity to the coil (16) can be changed between a far position and a near position,
with an actuating element (20) which is mechanically connected to the control element (23),
with a sprung curved washer (19) which is active between the line carrier (15) and the actuating element (20),
**characterised in that** a contact set (29) is arranged between the sprung curved washer (19) and the coil (16) and forms a contact switch.

2. Pushbutton switch according to claim 1, **characterised in that** the coil (16) is electrically connected to an evaluation circuit (27) which detects at least one electrical property of the coil (16) in order to generate a switch signal on the basis of a change in said property and thus form a contactless switch.

3. Pushbutton according to claim 2, **characterised in that** the evaluation circuit (27) is configured such that it continuously or periodically conducts an alternating voltage signal to the coil (16).

4. Pushbutton according to claim 2, **characterised in that** the electrical property of the coil (16) is its inductance, its effective ohmic resistance, its quality, its loss factor, its loss angle, its time constant or a resonance frequency established with a given capacitor.

5. Pushbutton according to any of the preceding claims, **characterised in that** in the absence of the control element (23), the coil (16) has a time constant (L/R) which is less than 1 µs, preferably less than 0.5 µs and preferably less than 0.1 µs.

6. Pushbutton according to any of the preceding claims, **characterised in that** the coil (16) consists of a print comprising a conductive ink applied to the line carrier (15).

7. Pushbutton according to any of the preceding claims, **characterised in that** the coil has an ohmic resistance between 0.2 Ohm and 20 Ohm, preferably between 2 Ohm and 12 Ohm, and preferably an inductance between 0.1 µH and 20 µH, further preferably between 0.5 µH and 2 µH.

8. Pushbutton according to any of the preceding claims, **characterised in that** the coil (16) is arranged between the line carrier (15) and a protective layer (18).

9. Pushbutton according to any of the preceding claims, **characterised in that** the control element (23) consists of a metal or an electrically conductive plastic material.

10. Pushbutton according to any of the preceding claims, **characterised in that** the control element (23) is formed by the sprung curved washer (19) itself.

11. Pushbutton according to any of the preceding claims, **characterised in that** the sprung curved washer (19) has a curvature whose convex side faces the coil (16).

12. Pushbutton according to claim 1, **characterised in that** the contact set (29) is formed by a film arrangement (28).

13. Pushbutton according to claim 8, **characterised in that** the protective layer (18) is formed by a line carrier film of the film arrangement (28) which carries a spacer film (33) that is provided with a switch contact carrier film (34).

14. Pushbutton according to any of claims 2 to 13, wherein the evaluation circuit (27) is configured to check the coincidence of actuation of the contactless switch and of the contact switch.

## Revendications

1. Interrupteur à touche en particulier pour l'actionnement manuel, avec un support de circuit (15) qui présente au moins une bobine (16) se composant d'un circuit imprimé,
avec un élément de commande (23) électroconducteur qui est associé à la bobine (16) et dont la proximité à la bobine (16) est modifiable entre une position éloignée et une position proche,
avec un élément d'actionnement (20) qui est relié mécaniquement à l'élément de commande (23),
avec un ressort en rondelle à déclic (19) qui est actif entre le support de circuit (15) et l'élément d'actionnement (20),
**caractérisé en ce**
**qu'**un jeu de contact (29) est agencé entre le ressort en rondelle à déclic (19) et la bobine (16), lequel forme un interrupteur à contact.

2. Interrupteur à touche selon la revendication 1, **caractérisé en ce que** la bobine (16) est reliée électriquement à un circuit d'évaluation (27) qui détecte au moins une propriété électrique de la bobine (16) afin de générer au moyen de sa modification un signal de commutation et de former ainsi un interrupteur sans contact.

3. Interrupteur à touche selon la revendication 2, **caractérisé en ce que** le circuit d'évaluation (27) est réalisé de telle manière qu'il conduise en permanence ou périodiquement un signal de tension alternative à la bobine (16).

4. Interrupteur à touche selon la revendication 2, **caractérisé en ce que** la propriété électrique de la bobine (16) est son inductance, sa résistance ohmique active, sa qualité, son facteur de perte, son angle de perte, sa constante de temps ou une fréquence de résonance fixée à un condensateur donné.

5. Interrupteur à touche selon l'une des revendications précédentes, **caractérisé en ce que** la bobine (16) présente en l'absence de l'élément de commande (23) une constante de temps (L/R) qui est inférieure à 1 µs, de préférence inférieure à 0,5 µs et de manière davantage préférée inférieure à 0,1 µs.

6. Interrupteur à touche selon l'une des revendications précédentes, **caractérisé en ce que** la bobine (16) se compose d'une impression appliquée sur le support de circuit (15) en encre conductrice.

7. Interrupteur à touche selon l'une des revendications précédentes, **caractérisé en ce que** la bobine présente une résistance ohmique entre 0,2 ohm et 20 ohms, de préférence entre 2 ohms et 12 ohms ainsi que de préférence une inductance entre 0,1 µH et 20 µH, de manière davantage préférée entre 0,5 µH et 2 µH.

8. Interrupteur à touche selon l'une des revendications précédentes, **caractérisé en ce que** la bobine (16) est agencée entre le support de conduite (15) et une couche de protection (18).

9. Interrupteur à touche selon l'une des revendications précédentes, **caractérisé en ce que** l'élément de commande (23) se compose d'un métal ou d'un matériau plastique électroconducteur.

10. Interrupteur à touche selon l'une des revendications précédentes, **caractérisé en ce que** l'élément de commande (23) est formé par le ressort en rondelle à déclic (19) même.

11. Interrupteur à touche selon l'une des revendications précédentes, **caractérisé en ce que** le ressort en rondelle à déclic (19) présente une courbure dont le côté convexe est tourné vers la bobine (16).

12. Interrupteur à touche selon la revendication 1, **caractérisé en ce que** le jeu de contact (29) est formé par un agencement de film (28).

13. Interrupteur à touche selon la revendication 8, **caractérisé en ce que** la couche de protection (18) est formée par un film de support de circuit de l'agencement de film (28) sur lequel un film d'espacement (33) est agencé, lequel est pourvu d'un film de support de contact de commutation (34).

14. Interrupteur à touche selon l'une des revendications 2 à 13, dans lequel le circuit d'évaluation (27) est aménagé afin de vérifier la coïncidence de l'actionnement de l'interrupteur sans contact et de l'interrupteur à contact.
